# EUROPÄISCHE PATENTSCHRIFT

(11) **EP 3 245 725 B1**
(45) Veröffentlichungstag und Bekanntmachung des Hinweises auf die Patenterteilung: **21.04.2021**
(21) Anmeldenummer: 15709865.8
(22) Anmeldetag: 27.02.2015
(51) Int. Cl.: H02M 7/00, H05K 5/06

(54) **ANORDNUNG MIT EINEM STROMRICHTER**
ARRANGEMENT HAVING A POWER CONVERTER
SYSTÈME COMPORTANT UN REDRESSEUR

(43) Veröffentlichungstag der Anmeldung: 22.11.2017
(73) Patentinhaber: Siemens Energy Global GmbH & Co. KG, 81739 München (DE)
(72) Erfinder: DORN, Jörg, 96155 Buttenheim (DE); KNAAK, Hans-Joachim, 91054 Erlangen (DE); SACHS, Günter, 91074 Herzogenaurach (DE)
(86) Internationale Anmeldenummer: PCT/EP2015/054179
(87) Internationale Veröffentlichungsnummer: WO 2016/134789

(56) Entgegenhaltungen:
- WO-A1-2014/131456
- US-A- 4 441 150

## Beschreibung

Die Erfindung betrifft eine Anordnung mit einem Stromrichter und ein Verfahren zum Beeinflussen von Umgebungsbedingungen eines Stromrichters.

Stromrichter sind leistungselektronische Schaltungen zum Umformen von elektrischer Energie. Beispiele für Stromrichter (Power Converter) sind Gleichrichter (Rectifier), Wechselrichter (Power Inverter) oder Wechselstrom-Umrichter (AC/AC-Converter). Stromrichter weisen eine Mehrzahl von elektrischen Bauteilen auf. Solche Bauteile können z.B. elektronische Bauelemente sein oder Baugruppen, welche mehrere elektronische Bauelemente aufweisen. Insbesondere können solche Bauteile leistungselektronische Bauteile mit Ventilfunktion sein (also leistungselektronische Bauteile, die den Strom nur in einer Richtung passieren lassen). Insbesondere bei Stromrichtern für hohe Spannungen weisen die Bauteile oft mehrere leistungselektronische Bauelemente auf, welche elektrisch in Reihe geschaltet sind. Durch die elektrische Reihenschaltung lassen sich die benötigten hohen Sperrspannungen erreichen.

Die Schrift US 4 441 150 A offenbart eine Hochspannungs-Gleichrichtereinheit, bei der die Gleichrichterelemente in einem hermetisch abgedichteten Gehäuse angeordnet sind, das mit einem unter Druck stehenden Isoliergas gefüllt ist.

Aus der internationalen Patentanmeldung WO 2014/131456 A1 ist eine Umrichterstation bekannt, bei der ein Transformator, eine Glättungsdrossel und ein Diodengleichrichter in einem ölbefüllten Kapselungsgehäuse angeordnet sind. Ein Überbrückungsschalter ist in einem weiteren Kapselungsgehäuse angeordnet, dass mit Schwefelhexafluorid befüllt ist. Stromrichter werden bisher üblicherweise mit Luftisolierung aufgebaut. Dabei sind die elektrischen Bauteile gegeneinander und gegen die Umgebung mittels Luft isoliert. Bei hohen Spannungen ist für diese Luftisolierung ein beträchtlicher Abstand zwischen den einzelnen Bauteilen und zum Gehäuse des Stromrichters hin notwendig, um Spannungsüberschläge zu verhindern. Daher ist für die Realisierung von luftisolierten Stromrichtern ein beträchtlicher Platz notwendig; diese luftisolierten Stromrichter nehmen einen beträchtlichen Raum ein.

Der Erfindung liegt die Aufgabe zugrunde, eine Anordnung sowie ein Verfahren anzugeben, mit denen der für Stromrichter benötigte Platz/Raum verkleinert werden kann.

Diese Aufgabe wird erfindungsgemäß gelöst durch eine Anordnung und durch ein Verfahren nach den unabhängigen Patentansprüchen. Vorteilhafte Ausführungsformen der Anordnung bzw. des Verfahrens sind in den jeweiligen abhängigen Patentansprüchen angegeben.

Offenbart wird eine Anordnung mit einem Stromrichter, der eine Mehrzahl von elektrischen Bauteilen aufweist, mit einem Gehäuse, das mindestens eines der Bauteile umgibt, und mit einer Druckerhöhungseinrichtung zum Erhöhen des Drucks eines in dem Gehäuse befindlichen gasförmigen Stoffes (gegenüber dem (außerhalb des Gehäuses herrschenden) Außendruck). Vorteilhafterweise weist diese Anordnung eine Druckerhöhungseinrichtung zum Erhöhen des Drucks des gasförmigen Stoffes auf. Eine Erhöhung des Drucks des gasförmigen Stoffes (Erhöhung des Gasdrucks) vergrößert grundsätzlich die Durchschlagfestigkeit des gasförmigen Stoffes. Dadurch kann der Abstand zwischen den Bauteilen des Stromrichters verringert werden bzw. aus mehreren Bauelementen aufgebaute Bauteile können kompakter aufgebaut werden. Dadurch kann der für den Stromrichter benötigte Platz/Raum deutlich verkleinert werden.

Die Anordnung kann so ausgestaltet sein, dass die Druckerhöhungseinrichtung eingerichtet ist, den Druck in dem Gehäuse auf einen Wert zwischen 1,1 Bar und 3 Bar, insbesondere auf einen Wert zwischen 1,1 Bar und 2 Bar, zu erhöhen. Vorteilhafterweise ist die Druckerhöhungseinrichtung eingerichtet bzw. ausgestaltet den Druck auf maximal 3 Bar, insbesondere auf maximal 2 Bar, zu erhöhen. Es hat sich herausgestellt, dass bei Drücken von höchstens 3 Bar die Durchschlagfestigkeit des gasförmigen Stoffes in der Regel bereits vergrößert ist. Der Aufwand zur Realisierung eines diesem (relativ geringen) Druck widerstehenden Gehäuses ist vorteilhafterweise vergleichsweise gering (notwendige mechanische Stabilität des Gehäuses, notwendige Wandstärke des Gehäuses, Stabilität von Dichtungen etc.). Diese moderate Druckerhöhung auf höchstens 3 Bar lässt sich technisch also relativ leicht und kostengünstig umsetzen. Mit anderen Worten lässt sich ein Druck von höchstens 3 Bar technisch relativ einfach beherrschen. Noch leichter lässt sich der Druck beherrschen, wenn er durch die Druckerhöhungseinrichtung auf maximal 2 Bar erhöht wird. Daher ist eine Druckerhöhungseinrichtung vorteilhaft, welche derart eingerichtet bzw. ausgestaltet ist, den Druck auf maximal 2 Bar zu erhöhen. Diese Einrichtung bzw. Ausgestaltung der Druckerhöhungseinrichtung kann beispielsweise durch eine entsprechend programmierte Steuerung oder Regelung realisiert werden.

Die Anordnung kann auch so ausgestaltet sein, dass die Anordnung eine Befeuchtungseinrichtung zum Vergrößern der Menge von in dem Gehäuse eingeschlossenem Wasserdampf und/oder eine Entfeuchtungseinrichtung zum Verringern der Menge des in dem Gehäuse eingeschlossenen Wasserdampfs aufweist. Der gasförmige Stoff weist also Wasserdampf auf; mit anderen Worten enthält der gasförmige Stoff Wasserdampf. Mittels der Befeuchtungseinrichtung kann die Menge des im Gehäuse eingeschlossenen Wasserdampfs beeinflusst werden. Insbesondere kann mittels dieser Befeuchtungseinrichtung verhindert werden, dass in dem Gehäuse sehr wenig Wasserdampf vorhanden ist (gasförmiger Stoff ist sehr trocken) oder das in dem Gehäuse sehr viel Wasserdampf vorhanden ist (gasförmiger Stoff ist sehr feucht). Sehr trockene gasförmige Stoffe und sehr feuchte gasförmige Stoffe weisen nämlich in der Regel eine vergleichsweise geringe elektrische Durchschlagfestigkeit auf. Somit kann mittels der Befeuchtungseinrichtung bzw. der Entfeuchtungseinrichtung sichergestellt werden, dass sich die Menge des in dem Gehäuse eingeschlossenen Wasserdampfs in einem Bereich bewegt, in dem der gasförmige Stoff eine vergleichsweise große Durchschlagfestigkeit aufweist.

Die Anordnung kann so ausgestaltet sein, dass die Befeuchtungseinrichtung und/oder die Entfeuchtungseinrichtung eingerichtet sind, die relative Feuchtigkeit in dem Gehäuse auf einen Wert zwischen 30 % und 50 % einzustellen. Es hat sich herausgestellt, dass bei einem Wert zwischen 30 % und 50 % relativer Feuchtigkeit in dem gasförmigen Stoff in der Regel eine deutliche Erhöhung der Durchschlagfestigkeit gegenüber trockeneren gasförmigen Stoffen oder feuchteren gasförmigen Stoffen vorliegt. Ein besonders vorteilhafter Wert für die in dem gasförmigen Stoff auftretende relative Feuchtigkeit liegt bei 40 %.

Die Anordnung kann auch so ausgestaltet sein, dass die Anordnung eine Heizeinrichtung zum Erhöhen der Temperatur in dem Gehäuse und/oder eine Kühleinrichtung zum Verringern der Temperatur in dem Gehäuse aufweist. Mittels der Heizeinrichtung bzw. der Kühleinrichtung lässt sich die Temperatur in dem Gehäuse beeinflussen. Bei zu hohen Temperaturen sinkt in der Regel die Durchschlagsfestigkeit des gasförmigen Stoffes ab, bei zu niedrigen Temperaturen besteht die Gefahr der Bildung eines Kondensats in dem gasförmigen Stoff. Somit kann mittels der Heizeinrichtung bzw. der Kühleinrichtung eine Temperatur in dem gasförmigen Stoff erreicht werden, welche eine vergleichsweise hohe Durchschlagfestigkeit des gasförmigen Stoffes zur Folge hat. Die Anordnung kann auch so ausgestaltet sein, dass die Heizeinrichtung und/oder die Kühleinrichtung eingerichtet sind, die Temperatur in dem Gehäuse auf einen Wert zwischen 5 Grad Celsius und 40 Grad Celsius einzustellen. Vorteilhafterweise ist die Heizeinrichtung und/oder die Kühleinrichtung derart eingerichtet bzw. ausgestaltet, das eine Temperatur zwischen 5 Grad Celsius und 40 Grad Celsius in dem Gehäuse eingestellt wird. Bei einer Temperatur innerhalb dieses Temperaturbereichs ist die Durchschlagfestigkeit des gasförmigen Stoffes in der Regel vergrößert gegenüber höheren Temperaturen. Insbesondere kann die Heizeinrichtung und/oder die Kühleinrichtung derart eingerichtet bzw. ausgestaltet sein, dass eine Temperatur zwischen 5 Grad Celsius und 15 Grad Celsius in dem Gehäuse eingestellt wird. Eine Erniedrigung der Temperatur um 30 Grad Celsius verbessert die Durchschlagfestigkeit um ca. 10 %.

Die Anordnung kann auch so ausgestaltet sein, dass der gasförmige Stoff diejenigen Gase aufweist, die in Luft enthalten sind, wobei die Konzentrationen von mindestens zwei dieser Gase des gasförmigen Stoffes sich unterscheiden von den Konzentrationen der jeweiligen Gase in Luft. Diese Variante erlaubt es vorteilhafterweise, durch eine Änderung der Konzentrationen der mindestens zwei Gase die Durchschlagfestigkeit noch weiter zu erhöhen. Dabei kann von üblicher Umgebungsluft ausgegangen werden, der ein Gas (welches in Luft sowieso enthalten ist) zusätzlich beigefügt wird. Auch dadurch lässt sich die Durchschlagfestigkeit des gasförmigen Stoffes erhöhen.

Vorteilhafterweise wird durch die Erhöhung der Konzentration des Stickstoffs und/oder die Erhöhung der Konzentration des Kohlendioxids die Durchschlagfestigkeit des gasförmigen Stoffes vergrößert. Die Konzentration von Stickstoff in Luft beträgt ca. 78 %, die Konzentration von Kohlendioxid in Luft beträgt ca. 0,04 %. Kohlendioxid CO₂ wird auch als Kohlenstoffdioxid bezeichnet.

Die Anordnung kann auch so ausgestaltet sein, dass der gasförmige Stoff das Gas Kohlendioxid in einer Konzentration größer als 2 %, insbesondere in einer Konzentration größer als 10 %, aufweist. Bei diesen Konzentrationen des Kohlendioxids ist die Durchschlagfestigkeit des gasförmigen Stoffes gegenüber der Durchschlagfestigkeit von Luft bereits deutlich vergrößert. Zu beachten ist, dass beim Einatmen von Kohlendioxid in einer Konzentration größer als ca. 5 % beim Menschen Kopfschmerzen, Schwindel oder Bewusstlosigkeit auftreten können. Daher sollten geeignete Vorkehrungen getroffen werden, damit bei einer Wartung oder Reparatur des Stromrichters ein Einatmen von großen Mengen Kohlendioxid verhindert wird.

Die Anordnung kann so ausgestaltet sein, dass das mindestens eine Bauteil ein leistungselektronisches Bauelement, insbesondere ein Leistungshalbleiter-Bauelement, aufweist. So kann der benötigte Platz für Stromrichter mit leistungselektronischen Bauelementen bzw. mit Leistungshalbleiter-Bauelementen verringert werden.

Die Anordnung kann auch so ausgestaltet sein, dass der Stromrichter ein Hochspannungs-Stromrichter ist (der insbesondere für Spannungen größer als 20 kV ausgelegt ist). Bei derartigen Hochspannungs-Stromrichtern wird aufgrund der hohen Spannung bei herkömmlicher Luftisolation ein besonders großer Platz/Raum zur Isolierung benötigt, der sich durch die vorstehend beschriebenen Anordnungen deutlich reduzieren lässt.

Offenbart wird weiterhin ein Verfahren zum Beeinflussen von Umgebungsbedingungen eines Stromrichters, der eine Mehrzahl von elektrischen Bauteilen aufweist, wobei mindestens eines der Bauteile in einem Gehäuse angeordnet ist, wobei bei dem Verfahren der Druck eines in dem Gehäuse befindlichen gasförmigen Stoffes (gegenüber dem (außerhalb des Gehäuses herrschenden) Außendruck) erhöht wird.

Dieses Verfahren kann so ausgestaltet sein, dass der Druck des gasförmigen Stoffs auf einen Wert innerhalb eines vorgegebenen Druckbereichs eingestellt (insbesondere erhöht) wird.

Das Verfahren kann so ausgestaltet sein, dass der Druck des gasförmigen Stoffs auf einen Wert zwischen 1,1 Bar und 3 Bar, insbesondere auf einen Wert zwischen 1,1 Bar und 2 Bar, eingestellt (insbesondere erhöht) wird.

Das Verfahren kann auch so ausgestaltet sein, dass die Menge von in dem gasförmigen Stoff enthaltenen Wasserdampf beeinflusst (insbesondere vergrößert oder verkleinert) wird. Der gasförmige Stoff weist hierbei also Wasserdampf auf.

Das Verfahren kann auch so ablaufen, dass die Menge des in dem gasförmigen Stoff enthaltenen Wasserdampfes derart beeinflusst wird, dass der gasförmige Stoff eine relative Feuchtigkeit zwischen 30 % und 50 % aufweist.

Das Verfahren kann so ausgestaltet sein, dass die Temperatur des gasförmigen Stoffes auf einen Wert innerhalb eines vorgegebenen Temperaturbereichs eingestellt wird.

Das Verfahren kann so ablaufen, dass die Temperatur des gasförmigen Stoffes auf einen Wert zwischen 5 Grad Celsius und 40 Grad Celsius eingestellt wird.

Das Verfahren kann so ablaufen, dass der gasförmige Stoff diejenigen Gase aufweist, die in Luft enthalten sind, und die Konzentrationen von mindestens zwei dieser Gase des gasförmigen Stoffes verändert werden gegenüber den Konzentrationen der jeweiligen Gase in Luft.

Das Verfahren kann auch so ausgestaltet sein, dass das mindestens eine Bauteil ein leistungselektronisches Bauelement, insbesondere ein Leistungshalbleiter-Bauelement, aufweist.

Das Verfahren kann so ausgestaltet sein, dass der Stromrichter ein Hochspannungs-Stromrichter ist. Dieser Hochspannungs-Stromrichter ist insbesondere für Spannungen größer als 20 kV ausgelegt.

Die beschriebenen Varianten des Verfahrens weisen gleichartige Vorteile auf, wie sie oben im Zusammenhang mit den Varianten der Anordnung beschrieben sind.

Im Folgenden wird die Erfindung anhand von Ausführungsbeispielen näher erläutert. Gleiche Bezugszeichen verweisen dabei auf gleiche oder gleichwirkende Elemente. Es ist in
- Figur 1: ein erstes Ausführungsbeispiel einer Anordnung mit einem Stromrichter, in
- Figur 2: ein weiteres Ausführungsbeispiel einer Anordnung mit einem Stromrichter und in
- Figur 3: ein Ausführungsbeispiel eines Verfahren zum Beeinflussen von Umgebungsbedingungen eines Stromrichters
dargestellt.

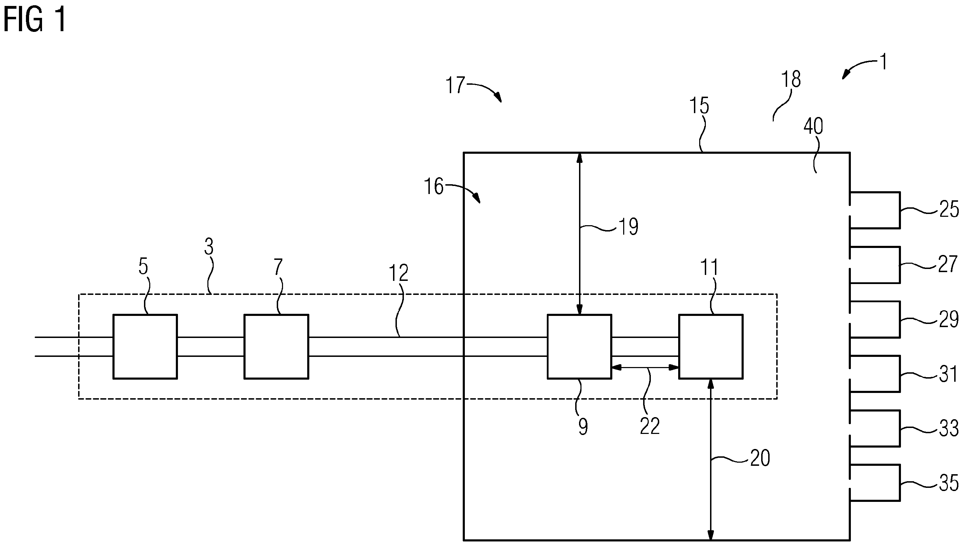

In Figur 1 ist eine Anordnung 1 mit einem Stromrichter 3 dargestellt. Dieser Stromrichter 3 weist ein erstes Bauteil 5, ein zweites Bauteil 7, ein drittes Bauteil 9 und ein viertes Bauteil 11 auf. Das dritte Bauteil 9 weist im Ausführungsbeispiel mehrere leistungselektronische Bauelemente auf, welche miteinander verschaltet sind und so die Funktion des dritten Bauteils 9 realisieren. Das vierte Bauteil 11 weist im Ausführungsbeispiel lediglich ein einziges leistungselektronisches Bauelement auf (beispielsweise ein Leistungshalbleiter-Bauelement), welches die Funktion des vierten Bauteils des Stromrichters 3 realisiert. Derartige leistungselektronische Bauelemente können zum Beispiel ein Leistungs-Thyristor, eine Leistungs-Diode oder ein IGBT (insulated-gate bipolar transistor) sein. Die Bauteile 5, 7, 9 und 11 sind durch elektrische Leiter 12 elektrisch miteinander verbunden. Im Ausführungsbeispiel ist der Stromrichter 3 ein Hochspannungsstromrichter, der für Spannungen größer als 20 KV ausgelegt ist. Bei solchen hohen Spannungen ist es besonders wichtig, das Auftreten von Überschlägen zwischen den einzelnen Bauteilen bzw. zwischen den Bauteilen und dem Gehäuse zu verhindern.

Das dritte Bauteil 9 und das vierte Bauteil 11 sind von einem Gehäuse 15 umgeben. Das Gehäuse 15 besteht aus elektrisch leitendem Material und befindet sich auf einem definierten elektrischen Potential (beispielsweise auf Erdpotential, was durch eine Erdung des Gehäuses 15 erreicht werden kann). Das Gehäuse 15 weist einen Innenraum 16 und einen Außenraum 17 auf. Der Innenraum 16 ist der von dem Gehäuse 15 umschlossene Raum. Der Außenraum 17 ist der Raum, der das Gehäuse 15 umgibt. In dem Innenraum 16 des Gehäuses 15 sind also die Bauteile 9 und 11 des Stromrichters 3 angeordnet. Außerhalb des Gehäuses 15 befindet sich der Außenraum 17, dieser Außenraum 17 ist zumindest teilweise mit Luft (Umgebungsluft) 18 gefüllt. Das erste Bauteil 5 und das zweite Bauteil 7 befinden sich im Außenraum 17 des Gehäuses 15.

Zwischen dem dritten Bauteil 9 und dem Gehäuse 15 ist schematisch ein erster Abstand 19 eingezeichnet. Dieser erste Abstand 19 muss derart bemessen sein, dass beim Betrieb des Stromrichters zwischen dem dritten Bauteil 9 und dem Gehäuse 15 kein elektrischer Überschlag auftritt. Die notwendige Größe dieses ersten Abstands 19 ist abhängig von den Umgebungsbedingungen des Stromrichters, die in dem Gehäuse 15 vorliegen. Weiterhin ist zwischen dem vierten Bauteil 11 und dem Gehäuse 15 symbolisch ein zweiter Abstand 20 dargestellt. Dieser zweite Abstand 20 muss so groß sein, dass zwischen dem vierten Bauteil 11 und dem Gehäuse 15 kein elektrischer Überschlag auftritt. Weiterhin ist zwischen dem dritten Bauteil 9 und dem vierten Bauteil 11 ein dritter Abstand 22 dargestellt. Dieser dritte Abstand 22 muss derart groß sein, dass zwischen dem dritten Bauteil 9 und dem vierten Bauteil 11 kein elektrischer Überschlag auftritt.

Die Anordnung 1 weist eine Druckerhöhungseinrichtung 25, eine Befeuchtungseinrichtung 27, eine Entfeuchtungseinrichtung 29, eine Heizeinrichtung 31, eine Kühleinrichtung 33 und eine Gaszuführungseinrichtung 35 auf. Bei anderen Ausführungsbeispielen können auch eine oder mehrere der genannten Einrichtungen weggelassen werden. Beispielsweise kann die Heizeinrichtung 31 weggelassen werden, wenn sichergestellt ist, dass bei Betrieb des Stromrichters stets eine gewünschte Mindesttemperatur vorliegt.

Die Druckerhöhungseinrichtung 25 dient zum Erhöhen des Drucks eines in dem Gehäuse 15 eingeschlossenen gasförmigen Stoffes 40. Das Gehäuse 15 dient also zur Aufnahme des gasförmigen Stoffes 40. Der gasförmige Stoff 40 befindet sich im Innenraum 16 des Gehäuses 15. Mit anderen Worten ist das Gehäuse 15 mit dem gasförmigen Stoff 40 gefüllt. In dem Gehäuse 15 befinden sich mindestens eines der Bauteile des Stromrichters 3 (hier: das dritte Bauteil 9 und das vierte Bauteil 11) sowie der gasförmige Stoff 40.

Die Druckerhöhungseinrichtung 25 erhöht den Druck des gasförmigen Stoffes 40 gegenüber dem außerhalb des Gehäuses 15 auftretenden Aussendruck. Somit befindet sich innerhalb des Gehäuses 15 (d.h. im Innenraum 16) ein Überdruck. Die Druckerhöhungseinrichtung ist so ausgebildet, dass diese den Druck innerhalb des Gehäuses 15 auf einen vorgewählten Wert zwischen 1,1 Bar und 3 Bar einstellt (1 Bar = 100 kPa). Vorteilhafterweise kann die Druckerhöhungseinrichtung auch so ausgebildet sein, dass diese den Druck innerhalb des Gehäuses 15 auf einen vorgewählten Wert zwischen 1,1 Bar und 2 Bar einstellt. Dieser erhöhte Druck wird dann während des Betriebs des Stromrichters mittels der Druckerhöhungseinrichtung 25 auf dem gewählten Wert konstant gehalten. Dazu kann die Druckerhöhungseinrichtung 25 eine als solche bekannte Regelungseinrichtung aufweisen. Die Druckerhöhungseinrichtung 25 kann beispielsweise eine Pumpe oder ein Kompressor sein.

Die Befeuchtungseinrichtung 27 dient zum Vergrößern der Menge von in dem Innenraum 16 des Gehäuses 15 enthaltenem Wasserdampf; die Entfeuchtungseinrichtung 29 dient zum Verringern der Menge von in dem Innenraum 16 des Gehäuses 15 enthaltenem Wasserdampf. Die Befeuchtungseinrichtung 27 kann beispielsweise als ein Verdampfer (Wasser-Verdampfer) ausgebildet sein, während die Entfeuchtungseinrichtung 29 als eine Wasser-Kondensationseinrichtung ausgebildet ist. Mittels der Befeuchtungseinrichtung 27 und/oder der Entfeuchtungseinrichtung 29 wird die relative Feuchtigkeit im Innenraum 16 des Gehäuses 15 auf einen vorgewählten Wert zwischen 30 % und 50 % relativer Feuchtigkeit eingestellt bzw. geregelt. Beispielsweise stellt die Befeuchtungseinrichtung 27 und/oder die Entfeuchtungseinrichtung 29 die in dem gasförmigen Stoff auftretende relative Feuchtigkeit auf einen Wert von 40 % ein.

Mittels der Heizeinrichtung 31 kann die Temperatur des gasförmigen Stoffes 40 in dem Gehäuse 15 erhöht werden; mittels der Kühleinrichtung 33 kann die Temperatur des gasförmigen Stoffes 40 in dem Gehäuse 15 verringert werden. Die Heizeinrichtung 31 und/oder die Kühleinrichtung 33 sind so eingerichtet bzw. ausgestaltet, dass diese die Temperatur des gasförmigen Stoffes 40 im Innenraum 16 des Gehäuses 15 auf einen vorgewählten Wert zwischen 5 Grad Celsius und 40 Grad Celsius einstellen bzw. einzuregeln. Die Befeuchtungseinrichtung 27, die Entfeuchtungseinrichtung 29, die Heizeinrichtung 31 und/oder die Kühleinrichtung 33 können insbesondere durch eine als solche bekannte Klimaanlage realisiert sein.

Mittels der Gaszuführungseinrichtung 35 wird der gasförmige Stoff 40 in den Innenraum 16 des Gehäuses 15 eingebracht. Bei dem gasförmigen Stoff 40 kann es sich beispielsweise um Luft handeln. In diesem Fall ist die Gaszuführungseinrichtung als eine Luftzuführung ausgestaltet, welche Luft 18 aus dem Außenraum 17 des Gehäuses 15 in den Innenraum 16 des Gehäuses 15 befördert.

Der gasförmige Stoff 40 innerhalb des Gehäuses kann aber auch so ausgebildet sein, dass der gasförmige Stoff 40 zwar diejenigen Gase aufweist, welche auch in herkömmlicher Luft 18 enthalten sind. Allerdings unterscheiden sich die Konzentrationen von mindestens zwei dieser Gase des gasförmigen Stoffes von den Konzentrationen der jeweiligen Gase in herkömmlicher Luft. Dies wird dadurch erreicht, dass die Gaszuführungseinrichtung 35 einen oder mehrere Gasspeicher (z.B. Druckgasflaschen) aufweist und die Gaszuführungseinrichtung 35 ein in diesen Gasspeichern jeweils gespeichertes Gas in den Innenraum 16 des Gehäuses 15 abgibt.

Beispielsweise kann die Gaszuführungseinrichtung 35 einen Gasspeicher mit Stickstoff aufweisen. Die Gaszuführungseinrichtung 35 gibt dann kontrolliert Stickstoff aus diesem Gasspeicher in den Innenraum 16 des Gehäuses ab, dadurch wird die Konzentration des Stickstoffs gegenüber der Konzentration des Stickstoffs in herkömmlicher Luft erhöht. Natürlich können in der Gaszuführungsvorrichtung 35 auch Gasspeicher mit anderen Gasen enthalten sein, beispielsweise Gasspeicher mit Kohlendioxid oder Gasspeicher mit Argon.

Derartige Gase (die auch in herkömmlicher Umgebungsluft 18 enthalten sind) haben den Vorteil, dass sie in der Regel nicht oder nur wenig umweltschädlich und/oder ungiftig sind, sodass sie bei einer Wartung einfach in den Außenraum 17 (und dann in die Atmosphäre) abgelassen werden können. Dies ist beispielsweise ein erheblicher Vorteil gegenüber dem Gas Schwefelhexafluorid SF₆, welches zwar sehr gute Isolationseigenschaften aufweist, jedoch auch in hohem Maße klimaschädlich ist.

Mittels der Druckerhöhungseinrichtung 25, der Befeuchtungseinrichtung 27, der Entfeuchtungseinrichtung 29, der Heizeinrichtung 31, der Kühleinrichtung 33 und/oder der Gaszuführungseinrichtung 35 werden die im Innenraum 16 des Gehäuses 15 vorliegenden Umgebungsbedingungen des Stromrichters 3 beeinflusst. Im Ausführungsbeispiel der Figur 1 werden insbesondere die Umgebungsbedingungen des dritten Bauteils 9 und des vierten Bauteils 11 des Stromrichters beeinflusst. Insbesondere wird der das dritte Bauteil 9 und das vierte Bauteil 11 umgebende Druck, die das dritte Bauteil 9 und das vierte Bauteil 11 umgebende Feuchtigkeit und die das dritte Bauteil 9 und das vierte Bauteil 11 umgebende Temperatur beeinflusst und auf vorteilhafte Werte gebracht.

Mit anderen Worten wird im Innenraum 16 des Gehäuses 15 eine kontrollierte Atmosphäre geschaffen, in der mindestens eines der Bauteile des Stromrichters 3 (hier: das dritte Bauteil 9 und das vierte Bauteil 11) betrieben werden. Mittels der genannten Größen (Zusammensetzung des gasförmigen Stoffes, Druck, Feuchtigkeit und/oder Temperatur) wird erreicht, dass die Durchschlagfestigkeit des gasförmigen Stoffes 40 erhöht wird. Dadurch kann beispielsweise der dritte Abstand 22 zwischen dem dritten Bauteil 9 und dem vierten Bauteil 11 relativ klein sein. Ebenso kann der erste Abstand 19 zwischen dem dritten Bauteil 9 und dem Gehäuse 15 relativ klein sein. Ebenso kann auch der zweite Abstand 20 zwischen dem vierten Bauteil 11 und dem Gehäuse 15 relativ klein bemessen sein. Beispielsweise ist es denkbar, dass die erforderlichen Abstände um 50 % reduziert werden gegenüber einer herkömmlichen Luftisolierung. (Im Ausführungsbeispiel treten bei dem ersten Bauteil 5 und dem zweiten Bauteil 7 des Stromrichters 3 (welche sich außerhalb des Gehäuses 15 befinden) geringere Spannungen auf als an dem dritten Bauteil 9 und dem vierten Bauteil 11. Daher können das erste Bauteil 5 und das zweite Bauteil 7 außerhalb des Gehäuses 15 angeordnet sein.)

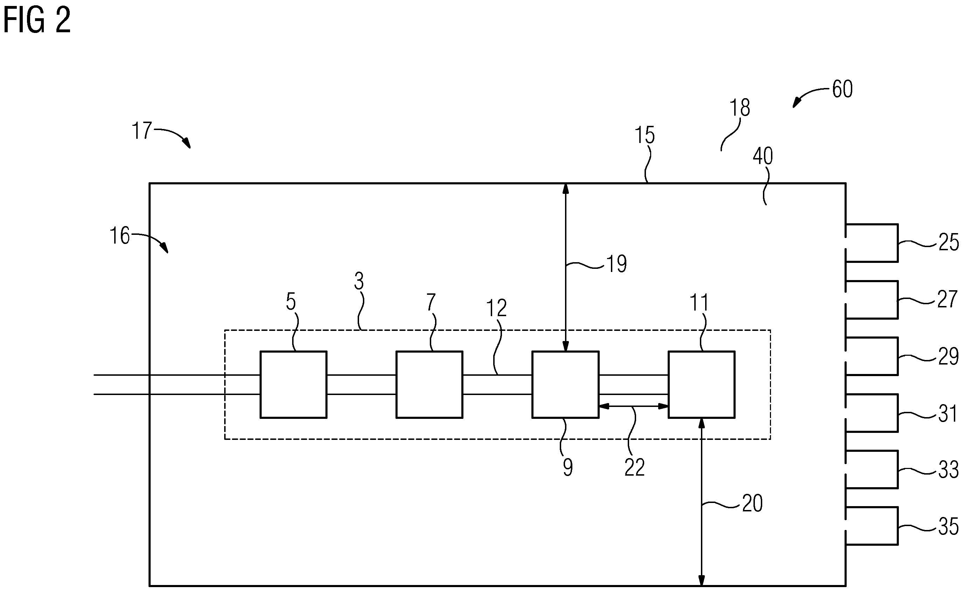

In Figur 2 ist ein weiteres Ausführungsbeispiel einer Anordnung 60 mit dem Stromrichter 3 dargestellt. Dieses Ausführungsbeispiel unterscheidet sich von dem Ausführungsbeispiel der Figur 1 lediglich dadurch, dass sämtliche Bauteile des Stromrichters (also das erste Bauteil 5, das zweite Bauteil 7, das dritte Bauteil 9 und das vierte Bauteile 11) im Innenraum 16 des Gehäuses 15 angeordnet sind.

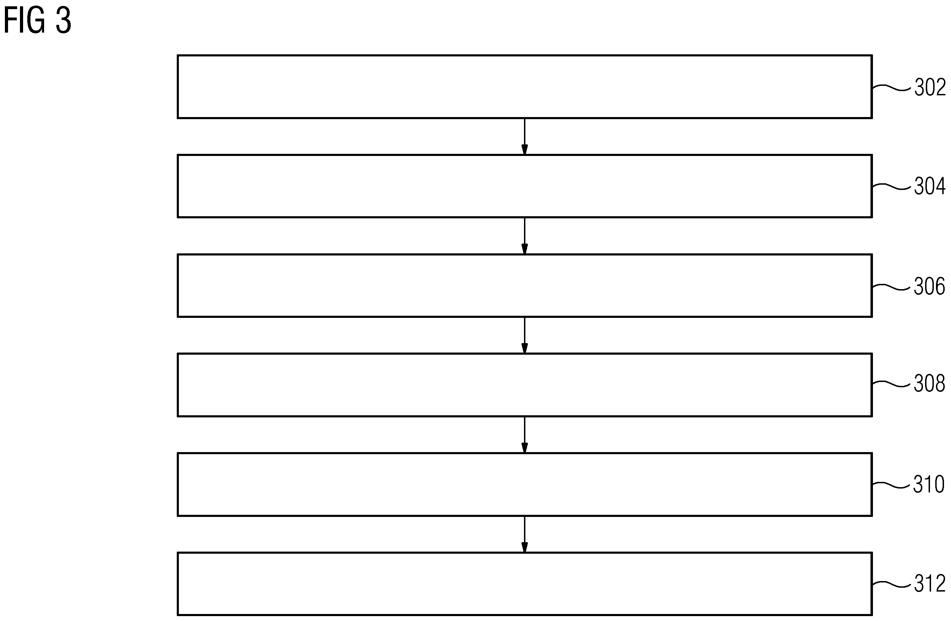

In Figur 3 ist ein beispielhafter Ablauf des Verfahrens zum Beeinflussen von Umgebungsbedingungen des Stromrichters 3 dargestellt. Dabei laufen folgende Verfahrensschritte ab:
- 302: Beeinflussen der Konzentrationen der Bestandteile des gasförmigen Stoffs
- 304: Erhöhen des Drucks des gasförmigen Stoffs
- 306: Beeinflussen der Menge des Wasserdampfs in dem gasförmigen Stoff (Beeinflussen der relativen Feuchtigkeit des gasförmigen Stoffs)
- 308: Beeinflussen der Temperatur des gasförmigen Stoffs
- 310: Einschalten des Stromrichters
- 312: Halten der Konzentrationen der Bestandteile des gasförmigen Stoffes, des Druck, der Menge des Wasserdampfs und/oder der Temperatur auf dem erreichten Wert

Dabei können einer oder mehrere der genannten Verfahrensschritte (insbesondere einer oder mehrere der Verfahrensschritte 302, 304, 306 und 308) weggelassen werden.

In dem ersten Verfahrensschritt 302 werden die Konzentrationen der Bestandteile des gasförmigen Stoffes 40 beeinflusst. Dies geschieht beispielsweise durch die Gaszuführungseinrichtung 35, welche ausgewählte Gase in den Innenraum 16 des Gehäuses 15 abgibt. In dem folgenden Verfahrensschritt 304 wird der Druck des gasförmigen Stoffes 40 in dem Innenraum 16 des Gehäuses 15 erhöht. Dies erfolgt beispielsweise durch die Druckerhöhungseinrichtung 25. Im darauffolgenden Verfahrensschritt 306 wird die Menge des Wasserdampfs in dem gasförmigen Stoff 40 (im Innenraum 16 des Gehäuses 15) beeinflusst. Mit anderen Worten wird die Feuchtigkeit des gasförmigen Stoffes 40 beeinflusst. Dies geschieht beispielsweise durch die Befeuchtungseinrichtung 27 und durch die Entfeuchtungseinrichtung 29. Im darauffolgenden Verfahrensschritt 308 wird die Temperatur des gasförmigen Stoffes 40 beeinflusst. Diese Temperaturbeeinflussung erfolgt beispielsweise durch die Heizeinrichtung 31 und die Kühleinrichtung 33. Im darauffolgenden Schritt 310 wird der Stromrichter eingeschaltet. Daraufhin beginnt der Stromrichter 3 zu arbeiten.

Im nächsten Verfahrensschritt 312 werden die Konzentrationen der Bestandteile des gasförmigen Stoffes 40, der Druck des gasförmigen Stoffes 40, die Menge des Wasserdampfs in dem gasförmigen Stoff 40 und/oder die Temperatur des gasförmigen Stoffes 40 auf dem jeweils gewünschten (vorgewählten) Wert gehalten. Dies kann beispielsweise mit einer oder mehreren Regelungen erfolgen. Dadurch werden diese Größen (Konzentrationen der Bestandteile des gasförmigen Stoffes 40, Druck, Menge des Wasserdampfs in dem gasförmigen Stoff 40 und/oder Temperatur) auf dem jeweils gewünschten Wert gehalten, solange der Stromrichter in Betrieb ist.

Die beschriebene Anordnung und das beschriebene Verfahren lassen sich besonders nutzbringend dort einsetzen, wo Platz bzw. benötigter Raum sehr teuer ist. Das ist beispielsweise auf Offshore-Anlagen (also beispielsweise auf im Meer stehenden Plattformen oder bei im Meer stehenden Türmen) der Fall. Wenn an solchen Orten Stromrichter installiert werden sollen, ist es außerordentlich kostensparend, wenn der benötigte Platz/Raum für die Installation solcher Stromrichter verringert werden kann. Dies kann vorteilhafterweise durch die beschriebene Anordnung bzw. das beschriebene Verfahren erfolgen. Die Kosten der gegenüber einer herkömmlichen Luftisolierung zusätzlich benötigten Elemente (Druckerhöhungseinrichtung, Befeuchtungseinrichtung, Heizeinrichtung usw.) sind in vielen Fällen weitaus geringer als die eingesparten Kosten für den weniger benötigten Platz/Raum für den Stromrichter. Somit ergibt sich eine Anordnung bzw. ein Verfahren, mit denen die Kosten für Stromrichter deutlich gesenkt werden können. Bei einer zukünftigen weiteren Erhöhung der Betriebsspannung von Stromrichtern könnte die erreichbare Kostensenkung sogar noch stärker ins Gewicht fallen.

## Patentansprüche

1. Anordnung
- mit einem Stromrichter (3), der eine Mehrzahl von elektrischen Bauteilen (5, 7, 9, 11) aufweist, und
- mit einem Gehäuse (15), das mindestens eines der Bauteile (9, 11) umgibt,
**gekennzeichnet durch**
- eine Druckerhöhungseinrichtung (25) zum Erhöhen des Drucks eines in dem Gehäuse befindlichen sauerstoffhaltigen gasförmigen Stoffes (40), wobei der gasförmige Stoff (40) Stickstoff und Kohlendioxid aufweist, wobei die Konzentration des Stickstoffs höher als 78 % und/oder die Konzentration des Kohlendioxids größer als 2 % ist.

2. Anordnung nach Anspruch 1,
**dadurch gekennzeichnet, dass**
- die Druckerhöhungseinrichtung (25) eingerichtet ist, den Druck in dem Gehäuse (15) auf einen Wert zwischen 1,1 Bar und 3 Bar, insbesondere auf einen Wert zwischen 1,1 Bar und 2 Bar, zu erhöhen.

3. Anordnung nach Anspruch 1 oder 2,
**dadurch gekennzeichnet, dass**
- die Anordnung eine Befeuchtungseinrichtung (27) zum Vergrößern der Menge von in dem Gehäuse (15) eingeschlossenem Wasserdampf und/oder eine Entfeuchtungseinrichtung (29) zum Verringern der Menge des in dem Gehäuse (15) eingeschlossenen Wasserdampfs aufweist.

4. Anordnung nach einem der vorhergehenden Ansprüche,
**dadurch gekennzeichnet, dass**
- die Befeuchtungseinrichtung (27) und/oder die Entfeuchtungseinrichtung (29) eingerichtet ist, die relative Feuchtigkeit in dem Gehäuse (15) auf einen Wert zwischen 30 % und 50 % einzustellen.

5. Anordnung nach einem der vorhergehenden Ansprüche,
**dadurch gekennzeichnet, dass**
- die Anordnung eine Heizeinrichtung (31) zum Erhöhen der Temperatur in dem Gehäuse (15) und/oder eine Kühleinrichtung (33) zum Verringern der Temperatur in dem Gehäuse (15) aufweist.

6. Anordnung nach einem der vorhergehenden Ansprüche,
**dadurch gekennzeichnet, dass**
- die Heizeinrichtung (31) und/oder die Kühleinrichtung (33) eingerichtet ist, die Temperatur in dem Gehäuse (15) auf einen Wert zwischen 5 Grad Celsius und 40 Grad Celsius einzustellen.

7. Anordnung nach einem der vorhergehenden Ansprüche,
**dadurch gekennzeichnet, dass**
- der gasförmige Stoff (40) diejenigen Gase aufweist, die in Luft enthalten sind, wobei die Konzentrationen von mindestens zwei dieser Gase des gasförmigen Stoffes (40) sich unterscheiden von den Konzentrationen der jeweiligen Gase in Luft.

8. Anordnung nach einem der vorhergehenden Ansprüche,
**dadurch gekennzeichnet, dass**
- das mindestens eine Bauteil (9) ein leistungselektronisches Bauelement, insbesondere ein Leistungshalbleiter-Bauelement, aufweist.

9. Anordnung nach einem der vorhergehenden Ansprüche,
**dadurch gekennzeichnet, dass**
- der Stromrichter (3) ein Hochspannungs-Stromrichter ist.

10. Verfahren zum Beeinflussen von Umgebungsbedingungen eines Stromrichters (3), der eine Mehrzahl von elektrischen Bauteilen (5, 7, 9, 11) aufweist, wobei mindestens eines der Bauteile (9, 11) in einem Gehäuse (15) angeordnet ist, wobei bei dem Verfahren
- der Druck eines in dem Gehäuse (15) befindlichen sauerstoffhaltigen gasförmigen Stoffes (40) erhöht wird, wobei der gasförmige Stoff (40) Stickstoff und Kohlendioxid aufweist, und
- die Konzentration des Stickstoffs auf einen Wert größer als 78 % erhöht wird und/oder die Konzentration des Kohlendioxids auf einen Wert größer als 2 % erhöht wird.

11. Verfahren nach Anspruch 10,
**dadurch gekennzeichnet, dass**
- der Druck des gasförmigen Stoffs (40) auf einen Wert innerhalb eines vorgegebenen Druckbereichs eingestellt wird.

12. Verfahren nach Anspruch 10 oder 11,
**dadurch gekennzeichnet, dass**
- der Druck des gasförmigen Stoffs (40) auf einen Wert zwischen 1,1 Bar und 3 Bar, insbesondere auf einen Wert zwischen 1,1 Bar und 2 Bar, eingestellt wird.

13. Verfahren nach einem der Ansprüche 10 bis 12,
**dadurch gekennzeichnet, dass**
- die Menge von in dem gasförmigen Stoff (40) enthaltenen Wasserdampf beeinflusst wird.

14. Verfahren nach einem der Ansprüche 10 bis 13,
**dadurch gekennzeichnet, dass**
- die Menge des in dem gasförmigen Stoff (40) enthaltenen Wasserdampfes derart beeinflusst wird, dass der gasförmige Stoff (40) eine relative Feuchtigkeit zwischen 30 % und 50 % aufweist.

15. Verfahren nach einem der Ansprüche 10 bis 14,
**dadurch gekennzeichnet, dass**
- die Temperatur des gasförmigen Stoffes (40) auf einen Wert innerhalb eines vorgegebenen Temperaturbereichs eingestellt wird.

16. Verfahren nach einem der Ansprüche 10 bis 15,
**dadurch gekennzeichnet, dass**
- die Temperatur des gasförmigen Stoffes (40) auf einen Wert zwischen 5 Grad Celsius und 40 Grad Celsius eingestellt wird.

17. Verfahren nach einem der Ansprüche 10 bis 16,
**dadurch gekennzeichnet, dass**
- der gasförmige Stoff (40) diejenigen Gase aufweist, die in Luft enthalten sind, und die Konzentrationen von mindestens zwei dieser Gase des gasförmigen Stoffes (40) verändert werden gegenüber den Konzentrationen der jeweiligen Gase in Luft.

18. Verfahren nach einem der Ansprüche 10 bis 17,
**dadurch gekennzeichnet, dass**
- das mindestens eine Bauteil (9) ein leistungselektronisches Bauelement, insbesondere ein Leistungshalbleiter-Bauelement, aufweist.

19. Verfahren nach einem der Ansprüche 10 bis 18,
**dadurch gekennzeichnet, dass**
- der Stromrichter (3) ein Hochspannungs-Stromrichter ist.

## Claims

1. Arrangement
- having a power converter (3) which has a plurality of electrical parts (5, 7, 9, 11), and
- having a housing (15) which surrounds at least one of the parts (9, 11),
**characterized by**
- a pressure-increasing device (25) for increasing the pressure of an oxygen-containing gaseous substance (40) in the housing, wherein the gaseous substance (40) has nitrogen and carbon dioxide, wherein the nitrogen concentration is higher than 78% and/or the carbon dioxide concentration is greater than 2%.

2. Arrangement according to Claim 1,
**characterized in that**
- the pressure-increasing device (25) is configured to increase the pressure in the housing (15) to a value of between 1.1 bar and 3 bar, in particular to a value of between 1.1 bar and 2 bar.

3. Arrangement according to Claim 1 or 2,
**characterized in that**
- the arrangement has a humidification device (27) for increasing the amount of water vapour enclosed in the housing (15) and/or a dehumidification device (29) for reducing the amount of water vapour enclosed in the housing (15).

4. Arrangement according to one of the preceding claims,
**characterized in that**
- the humidification device (27) and/or the dehumidification device (29) is/are configured to set the relative humidity in the housing (15) to a value of between 30% and 50%.

5. Arrangement according to one of the preceding claims,
**characterized in that**
- the arrangement has a heating device (31) for increasing the temperature in the housing (15) and/or a cooling device (33) for reducing the temperature in the housing (15).

6. Arrangement according to one of the preceding claims,
**characterized in that**
- the heating device (31) and/or the cooling device (33) is/are configured to set the temperature in the housing (15) to a value of between 5°C and 40°C.

7. Arrangement according to one of the preceding claims,
**characterized in that**
- the gaseous substance (40) has those gases which are included in air, wherein the concentrations of at least two of these gases of the gaseous substance (40) differ from the concentrations of the respective gases in air.

8. Arrangement according to one of the preceding claims,
**characterized in that**
- the at least one part (9) has a power electronic component, in particular a power semiconductor component.

9. Arrangement according to one of the preceding claims,
**characterized in that**
- the power converter (3) is a high-voltage power converter.

10. Method for influencing ambient conditions of a power converter (3) which has a plurality of electrical parts (5, 7, 9, 11), wherein at least one of the parts (9, 11) is arranged in a housing (15), wherein, in the method,
- the pressure of an oxygen-containing gaseous substance (40) in the housing (15) is increased, wherein the gaseous substance (40) has nitrogen and carbon dioxide, and
- the nitrogen concentration is increased to a value of greater than 78% and/or the carbon dioxide concentration is increased to a value of greater than 2%.

11. Method according to Claim 10,
**characterized in that**
- the pressure of the gaseous substance (40) is set to a value within a predefined pressure range.

12. Method according to Claim 10 or 11,
**characterized in that**
- the pressure of the gaseous substance (40) is set to a value of between 1.1 bar and 3 bar, in particular to a value of between 1.1 bar and 2 bar.

13. Method according to one of Claims 10 to 12,
**characterized in that**
- the amount of water vapour contained in the gaseous substance (40) is influenced.

14. Method according to one of Claims 10 to 13,
**characterized in that**
- the amount of water vapour contained in the gaseous substance (40) is influenced in such a manner that the gaseous substance (40) has a relative humidity of between 30% and 50%.

15. Method according to one of Claims 10 to 14,
**characterized in that**
- the temperature of the gaseous substance (40) is set to a value within a predefined temperature range.

16. Method according to one of Claims 10 to 15,
**characterized in that**
- the temperature of the gaseous substance (40) is set to a value of between 5°C and 40°C.

17. Method according to one of Claims 10 to 16,
**characterized in that**
- the gaseous substance (40) has those gases which are included in air, and the concentrations of at least two of these gases of the gaseous substance (40) are changed in comparison with the concentrations of the respective gases in air.

18. Method according to one of Claims 10 to 17,
**characterized in that**
- the at least one part (9) has a power electronic component, in particular a power semiconductor component.

19. Method according to one of Claims 10 to 18,
**characterized in that**
- the power converter (3) is a high-voltage power converter.

## Revendications

1. Système
- comprenant un redresseur (3), qui a une pluralité de composants (5, 7, 9, 11) électriques, et
- comprenant un boîtier (15), qui entoure au moins l'un des composants (9, 11),
**caractérisé par**
- un dispositif (25) d'élévation de la pression pour élever la pression d'une matière (40) gazeuse contenant de l'oxygène se trouvant dans le boîtier, la matière (40) gazeuse ayant de l'azote et du dioxyde de carbone, la concentration en azote étant plus grande que 78% et/ou la concentration en dioxyde de carbone étant plus grande que 2%.

2. Système suivant la revendication 1,
**caractérisé en ce que**
- le dispositif (25) d'élévation de la pression est conçu pour élever la pression dans le boîtier (15) à une valeur comprise entre 1,1 bar et 3 bar, notamment à une valeur comprise entre 1,1 bar et 2 bar.

3. Système suivant la revendication 1 ou 2,
**caractérisé en ce que**
- le système a un dispositif (27) d'humidification pour augmenter la quantité de vapeur d'eau renfermée dans le boîtier (15) et/ou un dispositif (29) de déshumidification pour diminuer la quantité de la vapeur d'eau renfermée dans le boîtier (15).

4. Système suivant l'une des revendications précédentes,
**caractérisé en ce que**
- le dispositif (27) d'humidification et/ou le dispositif (29) de déshumidification est conçu pour régler l'humidité relative dans le boîtier (15) à une valeur comprise entre 30% et 50%.

5. Système suivant l'une des revendications précédentes,
**caractérisé en ce que**
- le système a un dispositif (31) de chauffage pour élever la température dans le boîtier (15) et/ou un dispositif (33) de refroidissement pour abaisser la température dans le boîtier (15) .

6. Système suivant l'une des revendications précédentes,
**caractérisé en ce que**
- le dispositif (31) de chauffage et/ou le dispositif (33) de refroidissement est conçu pour régler la température dans le boîtier (15) à une valeur comprise entre 5 degré Celsius et 40 degré Celsius.

7. Système suivant l'une des revendications précédentes,
**caractérisé en ce que**
- la matière (40) gazeuse a les gaz, qui sont contenus dans l'air, la concentration en au moins deux de ces gaz de la matière (40) gazeuse se distinguant des concentrations des gaz respectifs dans l'air.

8. Système suivant l'une des revendications précédentes,
**caractérisé en ce que**
- le au moins un composant (9) a un composant de l'électronique de puissance, notamment un composant à semiconducteur de puissance.

9. Système suivant l'une des revendications précédentes,
**caractérisé en ce que**
- le redressement (3) est un redresseur de haute tension.

10. Procédé pour influer sur les conditions ambiantes d'un redresseur (3) qui a une pluralité de composants (5, 7, 9, 11) électriques, au moins l'un des composants (9, 11) étant disposé dans un boîtier (15), procédé dans lequel
- on élève la pression d'un matière gazeuse contenant de l'oxygène se trouvant dans le boîtier (15), la matière (40) gazeuse ayant de l'azote et du dioxyde de carbone, et
- on augmente la concentration de l'azote à une valeur plus grande que 78% et/ou on augmente la concentration du dioxyde de carbone à une valeur plus grande que 2%.

11. Procédé suivant la revendication 10,
**caractérisé en ce que**
- on règle la pression de la matière (40) gazeuse à une valeur dans une plage de pression donnée à l'avance.

12. Procédé suivant la revendication 10 ou 11,
**caractérisé en ce que**
- on règle la pression de la matière (40) gazeuse à une valeur comprise entre 1,1 bar et 3 bar, notamment à une valeur comprise entre 1,1 bar et 2 bar.

13. Procédé suivant l'une des revendications 10 à 12,
**caractérisé en ce que**
- on influe sur la quantité de vapeur d'eau contenue dans la matière (40) gazeuse.

14. Procédé suivant l'une des revendications 10 à 13,
**caractérisé en ce que**
- on influe sur la quantité de la vapeur d'eau contenue dans la matière (40) gazeuse de manière à ce que la matière (40) gazeuse ait une humidité relative comprise entre 30% et 50%.

15. Procédé suivant l'une des revendications 10 à 14,
**caractérisé en ce que**
- on règle la température de la matière (40) gazeuse à une valeur dans une plage de température donnée à l'avance.

16. Procédé suivant l'une des revendications 10 à 15,
**caractérisé en ce que**
- on règle la température de la matière (40) gazeuse à une valeur comprise entre 5 degré Celsius et 40 degré Celsius.

17. Procédé suivant l'une des revendications 10 à 16,
**caractérisé en ce que**
- la matière (40) gazeuse a les gaz, qui sont contenus dans l'air, la concentration en au moins deux de ces gaz de la matière (40) gazeuse se distinguant des concentrations des gaz respectifs dans l'air.

18. Procédé suivant l'une des revendications 10 à 17,
**caractérisé en ce que**
- le au moins un composant (9) a un composant de l'électronique de puissance, notamment un composant à semiconducteur de puissance.

19. Procédé suivant l'une des revendications 10 à 18,
**caractérisé en ce que**
- le redresseur (3) est un redressement de haute tension.
